# EUROPÄISCHE PATENTANMELDUNG

(11) **EP 4 521 126 A1**
(43) Veröffentlichungstag der Anmeldung: **12.03.2025**
(21) Anmeldenummer: 23196097.2
(22) Anmeldetag: 07.09.2023
(51) Int. Cl.: G01R 31/12, G01R 31/52, H02H 1/00, H01B 7/32

(54) **VORRICHTUNG MIT REDUNDANTEN VERSORGUNGSLEITUNGEN**

(71) Anmelder: Murrelektronik GmbH, 71570 Oppenweiler (DE)
(72) Erfinder: Fortwingel, Kai, 74232 Abstatt (DE); Wolff, Ingo, 74613 Öhringen (DE)
(74) Vertreter: Karzel, Philipp

(57) **Zusammenfassung**

Die Erfindung betrifft eine Vorrichtung mit einer elektrischen Versorgungsleitung (1) zwischen einem elektrischen Verbraucher (10) und einer Gleichspannungsquelle (20) mit einem Plus-Pol (21) und einem Minus-Pol (22). Die Versorgungsleitung (1) führt die zum Betrieb des Verbrauchers (10) notwendige 10 elektrische Energie zu. Nach der Erfindung ist vorgesehen, dass die elektrische Versorgungsleitung (1) aus zumindest vier nebeneinander verlaufenden, identisch ausgebildeten und isolierten Einzelleitern (E1, E2, E3, E4) gleicher Länge (L) besteht, wobei zumindest zwei Einzelleiter (E1, E2) den positiven Pol (21) mit dem Verbraucher (10) und zumindest zwei Einzelleiter (E3, E4) den negativen Pol (22) mit dem Verbraucher (10) verbinden. Jeder der Einzelleiter (E1, E2, E3, E4) bildet eine selbständige elektrische Verbindung zwischen der Gleichspannungsquelle (20) und dem elektrischen Verbraucher (10).

## Beschreibung

Die Erfindung betrifft eine Vorrichtung mit einer elektrischen Versorgungsleitung zwischen einem elektrischen Verbraucher und einer Gleichspannungsquelle mit einem Plus-Pol und einem Minus-Pol. Die Versorgungsleitung führt dem Verbraucher die zum Betrieb notwendige elektrische Energie zu.

In einer automatisierten Produktionsanlage verursachen unvorhersehbare Reparaturen und Ausfälle von Systemen und Maschinen Kosten und Zeitverzögerungen. Eine Ursache für einen Ausfall können gebrochene elektrische Leitungen sein. In einer automatisierten Produktionsanlage unterliegen elektrische Leitungen nicht nur elektrischen sondern auch mechanischen Belastungen. Zum Beispiel sind die elektrischen Leitungen in einer Schleppkette oder an Komponenten eines Roboters vorgesehen, die mechanische Bewegungen ausführen. Insbesondere können Störungen an Versorgungsleitungen von Sensoren, Aktoren oder I/O-Systemen (Input/Output-Systemen) zu erheblichen Stillstandszeiten führen, bis die fehlerhaften Versorgungsleitungen festgestellt und ausgetauscht werden können.

Ein besonderer Problemfall in automatisierten Produktionsanlagen ist das Auftreten eines Lichtbogens an einer gebrochenen elektrischen Versorgungsleitung. Die anliegenden Spannungen und Ströme können einen derartigen Lichtbogen aufrechterhalten, was auch zu Brandschäden führen kann.

Der Erfindung liegt die Aufgabe zugrunde, eine elektrische Versorgungsleitung in einer automatisierten Produktionsanlage derart auszulegen, dass die Gefahren bei auftretenden elektrischen Fehlern an der Versorgungsleitung und daraus resultierende Folgen wie Stillstandszeiten der Produktionsanlage und Brandgefahr durch Lichtbögen minimiert werden.

Nach der Erfindung ist vorgesehen, die elektrische Versorgungsleitung aus zumindest vier nebeneinander verlaufenden, im Wesentlichen identisch ausgebildeten und isolierten Einzelleitern von etwa gleicher Länge zu bilden. Zumindest zwei Einzelleiter verbinden den positiven Pol der Spannungsquelle mit dem Verbraucher und zumindest zwei weitere Einzelleiter verbinden den negativen Pol der Spannungsquelle mit dem Verbraucher. Die Auslegung erfolgt so, dass jede der Einzelleiter eine selbstständige elektrische Verbindung zwischen der Gleichspannungsquelle und dem elektrischen Verbraucher bildet.

Im Sinne der Erfindung kann ein Verbraucher aus einem einzelnen Gerät oder einer Ansammlung miteinander verschalteter Geräte bestehen. Auch eine Verschaltung von Gleichstromquellen, z. B. durch in Reihe schalten von einzelnen Batterien ist im Sinne der Erfindung als Gleichspannungsquelle zu verstehen.

Die redundante Energiezuführung zum elektrischen Verbraucher stellt sicher, dass bei einem Bruch eines Einzelleiters der andere Einzelleiter weiterhin eine stabile elektrische Verbindung zwischen der Gleichspannungsquelle und dem elektrischen Verbraucher gewährleistet. Vorzugsweise ist hierzu jede der Einzelleiter auf den Nennstrom des elektrischen Verbrauchers ausgelegt.

In der Produktionsanlage oder einem ähnlichen System sind die zumindest vier Einzelleiter in einem gemeinsamen Verbindungskabel zusammengefasst. Dies führt zu einer einfachen Montage und Demontage des Verbindungskabels. Zusätzlich kann das Kabel auch einen FE Leiter (FunktionsErdung) enthalten.

Vorteilhaft ist vorgesehen, dass die Einzelleiter einen gleichen elektrischen Widerstand haben. Insbesondere haben die Einzelleiter einen gleichen Querschnitt und bestehen vorzugsweise aus einem gleichen Material, vorzugsweise aus einer gleichen metallischen Legierung. Dabei ist vorgesehen, die Summe der Stromtragfähigkeit aller Einzelleiter auf zumindest den Nennstrom des angeschlossenen Verbrauchers auszulegen.

In einer ersten Variante der Dimensionierung wird die Summe der Stromtragfähigkeit der Einzelleiter auf mindestens den Nennstrom des Verbrauches ausgelegt. Die Stromtragfähigkeit eines Einzelleiters kann unterhalb des Nennstroms des Verbrauchers liegen. Bei dieser Auslegung muss bei der Detektion eines elektrischen Fehlers in einem Einzelleiter die Versorgung abgeschaltet werden. Der Fehler kann in dieser Variante als Leitungsbruch detektiert werden. Nachteilige Folgen wie z. B. Brände durch Lichtbögen können verhindert werden.

In einer zweiten Variante der Dimensionierung werden die parallelen Einzelleiter jeweils mindestens auf den Nennstrom des Verbrauchers ausgelegt. Hierdurch entsteht eine sogenannte 1+1 Redundanz. Bei dem Ausfall eines Einzelleiters kann die Anlage weiter betrieben werden. Die defekte Leitung kann in einem späteren Serviceintervall ausgetauscht werden.

In einer weiteren Variante der Dimensionierung werden mehr als zwei Einzelleiter parallelgeschaltet. Hierbei spricht man von einer n+1 Variante der Dimensionierung. Die Einzelleiter werden so ausgelegt, dass die Stromtragfähigkeit auf die Einzelleiter aufgeteilt ist. Es ist vorgesehen, dass die Anzahl der Einzelleiter, die systemisch nicht ausfallen dürfen, der Nennleistung des Verbrauchers entspricht. Wenn z.B. in einem System mit drei parallelen Einzelleitern systemisch eine Leitung ausfallen darf, müsste jeder der verbleibenden Einzelleiter die Stromtragfähigkeit von 50% der Nennlast des Verbrauchers tragen können. Diese Art der Redundanz ist besonders materialsparend.

Die Gleichspannungsquelle zur Versorgung des elektrischen Verbrauchers hat vorzugsweise eine Versorgungsspannung zwischen 24 V und 120 V Gleichspannung.

Für eine Fehlererkennung ist in Weiterbildung der Erfindung vorgesehen, zwischen mindestens zwei Einzelleitern zumindest eine Überwachungsvorrichtung anzuordnen. So kann die Überwachungsvorrichtung zwischen den Einzelleitern des den positiven Pol der Gleichspannungsquelle mit dem Verbraucher verbindenden Leitungspfad und oder zwischen den einzelnen Leitern des den negativen Pol der Spannungsquelle mit dem verbraucherverbindenden Leitungspfad vorgesehen sein.

In einer einfachen Ausbildung der Überwachungsvorrichtung erfasst diese die in den Einzelleitern fließenden Ströme und wertet deren Größe aus. Sind die Ströme unter Berücksichtigung auftretender Toleranzen als gleich zu bewerten, sind die Einzelleiter in Ordnung; tritt eine signifikante Stromdifferenz auf, liegt ein Fehler vor. Die Überwachungsvorrichtung ist ausgebildet, bei Auftreten einer Stromdifferenz oder sonstigen Fehlers ein Signal abzugeben und/oder eine Abschalteinrichtung auszulösen. Zur Erfassung der in den Einzelleitern fließenden Ströme ist in jedem der Einzelleiter jeweils ein Stromsensor vorgesehen.

In einer weiteren Ausbildung der Überwachungsvorrichtung ist vorgesehen, dass diese die elektromagnetischen Felder der in den Einzelleitern fließenden Ströme erfasst und auswertet. Hierzu wird die Größe der erfassten elektromagnetischen Felder von je zwei Einzelleitern miteinander verglichen um bei einer Felddifferenz ein Signal abzugeben und/oder eine Abschalteinrichtung auszulösen. So kann die Überwachungsvorrichtung die Differenz des Stromes in den Einzelleitern über das elektromagnetische Feld auswerten. Hierzu werden die Einzelleiter so verlegt, dass bei gleichen Stromfluss sich das elektromagnetische Feld an der Messstelle aufhebt. Sind die Ströme unterschiedlich, entsteht eine elektromagnetische Felddifferenz, die ausgewertet wird.

Es kann vorteilhaft sein, Leitungsabschnitte der Einzelleiter an der Messstelle als Spule auszubilden. Das entstehende Feld aus dem Differenzstrom wird durch einen Magnetfeldsensor, vorzugsweise einen Hallsensor, ausgewertet. Alternativ kann das Magnetfeld genutzt werden, um eine mechanische Komponente zu bedienen. Eine derartige mechanische Komponente kann ein Reedkontakt oder eine entsprechender Auslösemechanismus sein.

In einer weiteren Ausgestaltung der Erfindung ist vorgesehen, dass die Überwachungsvorrichtung die Temperatur an jeweils einer vorgewählten Verbindungsstelle der Einzelleiter erfasst und auswertet. Die Überwachungsvorrichtung vergleicht die an den vorgewählten Verbindungsstellen erfassten Temperaturen miteinander und ist ausgebildet, bei Auftreten einer Temperaturdifferenz ein Signal auszugeben und/oder eine Abschalteinrichtung auszulösen. In vorteilhafter Weise werden die einem Leitungspfad zugeordneten Verbindungsstellen der Einzelleiter miteinander verglichen. Die Verbindungsstelle der Einzelleiter kann zum Beispiel eine Lötstelle, ein Klemmanschluss, ein Steckanschluss oder eine Verbindung des Einzelleiters auf einer Leiterplatte sein. Die Verbindungsstellen, deren Temperaturen miteinander verglichen werden, liegen bevorzugt an einem gleichen Ende der Einzelleitungen.

In Weiterbildung der Erfindung ist vorgesehen, die Überwachungsvorrichtung auf einer Leiterplatte anzuordnen, die mit der Gleichspannungsquelle verbunden ist. Die Überwachungsvorrichtung und/oder die Leiterplatte ist eine Steckbuchse vorgesehen, in die der Stecker eines Verbindungskabels einsteckbar ist, das die zum Verbraucher führende Verbindungsleitung bildet.

Weitere Merkmale der Erfindung ergeben sich aus den weiteren Ansprüchen, der Beschreibung und den Zeichnungen, in denen Ausführungsbeispiele der Erfindung dargestellt sind. Die in den Ansprüchen angegebenen Merkmale, die in der Beschreibung genannten Merkmale und die den Zeichnungen dargestellten Merkmale können ohne Einschränkung miteinander kombiniert werden. Die Zeichnungen zeigen:
- Fig. 1: eine schematische Darstellung der Vorrichtung zur Verbindung eines elektrischen Verbrauchers mit einer Gleichspannungsquelle über zwei Leitungspfade mittels einer einzigen elektrischen Versorgungsleitung,
- Fig. 2: eine schematische Darstellung entsprechend Fig. 1 mit einer als Kabel ausgebildeten Versorgungsleitung,
- Fig. 3: eine schematische Darstellung gemäß Fig. 1 mit einer Überwachungsvorrichtung zu Erfassung und Auswertung der in den Einzelleitern eines Leitungspfades fließenden Ströme,
- Fig. 4: eine schematische Darstellung einer Überwachungsvorrichtung zu Erfassung und Auswertung der elektromagnetischen Felder zweier Einzelleitungen eines Leitungspfades der Verbindungsleitung,
- Fig. 5: eine schematische Darstellung gemäß Fig. 1 mit einer Überwachungsvorrichtung zur Erfassung und Auswertung der Temperaturen an ausgewählten Verbindungsstellen eines Leitungspfades der Versorgungsleitung,
- Fig. 6: eine schematische Darstellung einer Elektronik zur Erfassung und Auswertung der Temperaturen an zwei Verbindungsstellen an einem Ende des Leitungspfades der Versorgungsleitung.

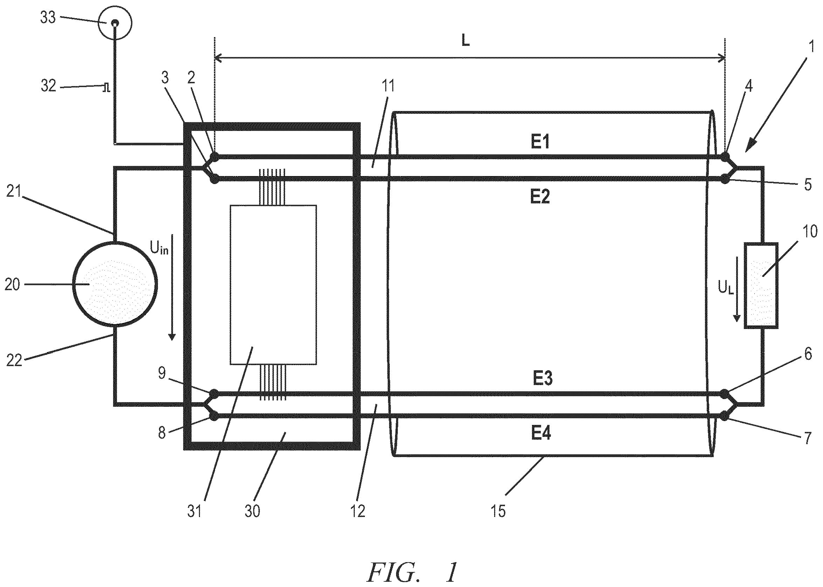

In Fig. 1 ist schematisch die Vorrichtung dargestellt, über die eine elektrische Verbindung zwischen einer Gleichspannungsquelle 20 und einem elektrischen Verbraucher 10 hergestellt ist. Die elektrische Verbindung ist durch zumindest vier Einzelleiter E1, E2, E3, E4 gebildet, die vorzugsweise nebeneinander verlaufen und als isolierte Einzelleiter E1, E2, E3, E4 ausgebildet sind.

Insbesondere sind die Einzelleiter E1, E2, E3, E4 gemeinsam in einem Verbindungskabel 15 zusammengefasst. Die Einzelleiter E1, E2, E3, E4 sind zweckmäßig gleich ausgebildet und haben vorzugsweise etwa gleiche, insbesondere gleiche Längen L. Wie dargestellt, verbinden zumindest zwei Einzelleiter E1 und E2 den positiven Pol 21 der Gleichspannungsquelle 20 mit dem elektrischen Verbraucher 10. Zumindest weitere zwei Einzelleiter E3 und E4 verbinden den negativen Pol 22 der Gleichspannungsquelle 20 mit dem Verbraucher 10. Die Gleichspannungsquelle 20 hat bevorzugt eine Versorgungsspannung U zwischen 24 und 120 V Gleichspannung.

Die Auslegung ist so getroffen, dass jede der Einzelleiter E1, E2, E3 und E4 eine selbstständige elektrische Verbindung zwischen der Gleichspannungsquelle 20 und dem elektrischen Verbraucher 10 bildet. Jeder Einzelleiter E1, E2, E3 und E4 ist insbesondere auf den zulässigen Nennstrom des angeschlossenen elektrischen Verbrauchers 10 ausgelegt. Die den Plus-Pol 21 der Gleichspannungsquelle 20 mit dem elektrischen Verbraucher 10 verbindenden Einzelleiter E1 und E2 bilden einen ersten elektrischen Leitungspfad 11. Die den Minus-Pol 22 der Gleichspannungsquelle 20 mit dem elektrischen Verbraucher 10 verbindenden Einzelleiter E3 und E4 bilden einen zweiten elektrischen Leitungspfad 12.

Der Plus-Pol 21 der Gleichspannungsquelle 20 ist über zwei Verbindungsstellen 2 und 3 mit jeweils einem der Einzelleiter E1 und E2 verbunden. Entsprechend sind die Einzelleiter E1 und E2 am anderen Ende der Einzelleiter E1 und E2 auf Seiten des elektrischen Verbrauchers 10 über Verbindungsstellen 4 und 5 elektrisch an den Verbraucher 10 angeschlossen. Die Verbindungsstellen 2 und 3 liegen an dem einen Ende des Leitungspfades 11. Die Verbindungsstellen 4 und 5 liegen an dem anderen Ende des Leitungspfades 11.

Die Einzelleiter E3 und E4 sind auf Seiten des elektrischen Verbrauchers über Verbindungsstellen 6 und 7 an diesen angeschlossen. Auf Seiten der Gleichspannungsquelle 20 sind die Einzelleiter E3 und E4 über Verbindungsstellen 8 und 9 an den Minus-Pol 22 der Gleichspannungsquelle 21 angeschlossen. Die Verbindungsstellen 6 und 7 liegen an dem einen Ende des Leitungspfades 12. Die Verbindungsstellen 8 und 9 liegen an dem anderen Ende des Leitungspfades 12.

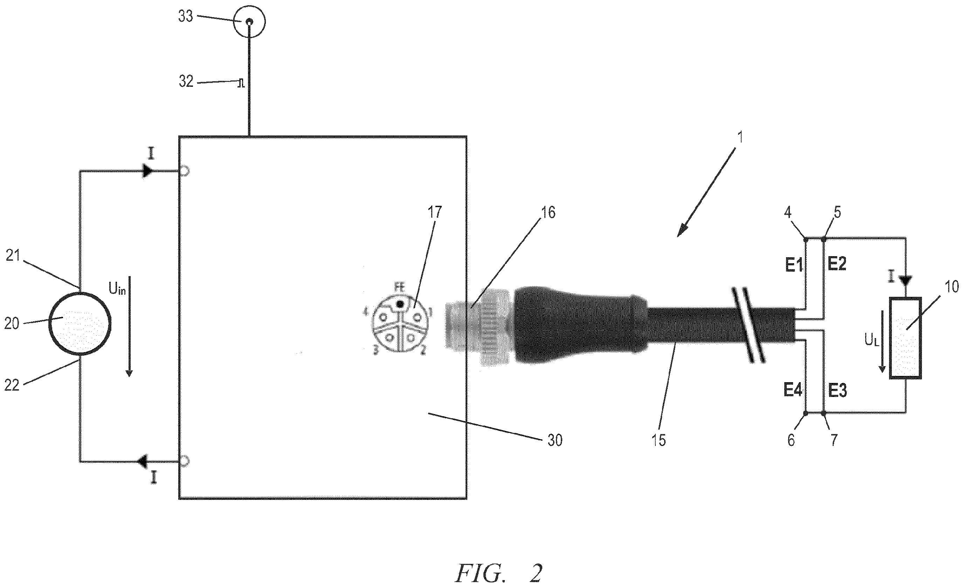

In Fig. 2 ist das Verbindungskabel 15 zum elektrischen Verbraucher 10 körperlich dargestellt. Das Verbindungskabel 15 wird mit einem Stecker 16 in eine Buchse 17 eingesteckt, die an der Überwachungsvorrichtung 30 und/oder an einer eine Überwachungselektronik 31 tragendenden Leiterplatte vorgesehen ist.

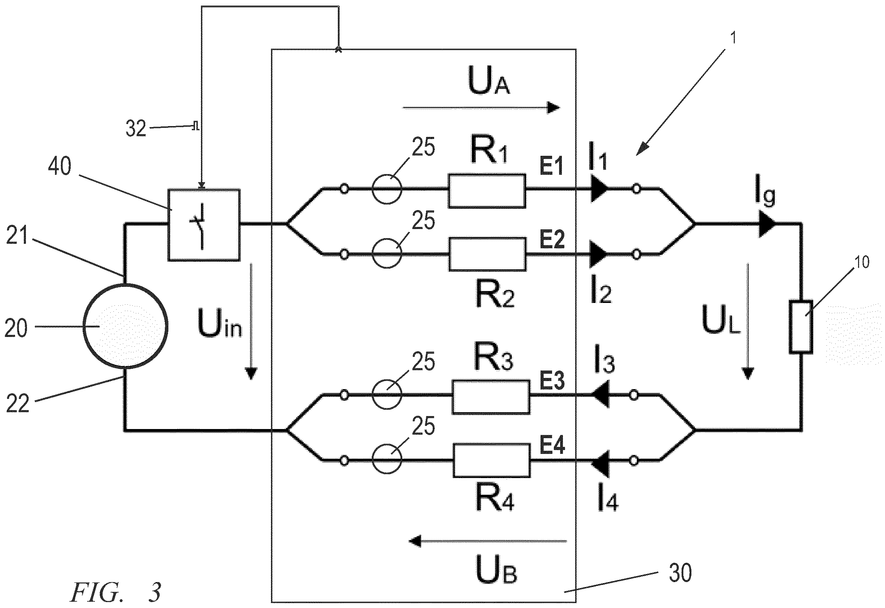

Zur Erkennung von elektrischen Fehlern der Einzelleitungen E1, E2, E3 und E4 ist eine Überwachungsvorrichtung 30 vorgesehen, die eine Überwachungselektronik 31 umfasst. Bei auftretenden Fehlern ist die Überwachungsvorrichtung 30 ausgebildet, ein elektrisches Signal 32 abzugeben. Das elektrische Signal 32 kann eine optische Anzeige 33 steuern oder, wie beispielhaft in Fig. 3 dargestellt, eine Abschalteinrichtung 40 aktivieren. Die Funktion der Überwachungsvorrichtung 30 wird nachfolgend in verschiedenen Ausführungsformen beschrieben.

Die Einzelleitungen E1, E2, E3 und E4 sind bevorzugt so ausgeführt, dass sie einen gleichen elektrischen Widerstand aufweisen. In der körperlichen Ausgestaltung der Einzelleiter E1, 2, E3 und E4 haben diese bevorzugt den gleichen Querschnitt. Zweckmäßig bestehen die Einzelleiter E1, 2, E3 und E4 aus einem gleichen Material bzw. aus einer gleichen Legierung.

Die dargestellte Überwachungsvorrichtung 30 ist so vorgesehen, dass die Überwachungselektronik 31 jeweils zwischen zwei Einzelleiter E1 und E2 des Leitungspfades 11 und/oder zwischen zwei Einzelleiter E3 und E4 des Leitungspfades 12 angeordnet ist.

In einer ersten Ausführungsform der Überwachungsvorrichtung 30 sind in den Einzelleitern E1, E2, E3 und E4 Stromsensoren 25 angeordnet, die die zufließenden Ströme I₁ und I₂ in den Einzelleitungen E1 und E2 und die abfließenden Ströme I₃ und I₄ in den Einzelleitungen E3 und E4 erfassen. Die Widerstände R₁ und R₂ der Einzelleitungen E1 und E2 sind aufgrund der gleichen Ausbildung der Einzelleitungen gleich. Über die Widerstände R₁ und R₂ fällt eine Spannung U_{A} ab. Die Widerstände R₃ und R₄ sind ebenfalls gleich; über sie fällt die Spannung U_{B} ab. Die Überwachungsvorrichtung 30 ist ausgebildet die Ströme I₁, I₂ und/oder I₃, I₄ miteinander zu vergleichen. Tritt z.B. ein Leitungsbruch der Einzelleitung E1 auf, ändern sich die Ströme I₁ und I₂. Tritt eine Stromdifferenz auf, wird die Überwachungsvorrichtung 30 - wie in Fig. 1 schematisch dargestellt - ein Signal 32 ausgeben und/oder eine Abschalteinrichtung 40 auslösen, um den Stromkreis zu unterbrechen.

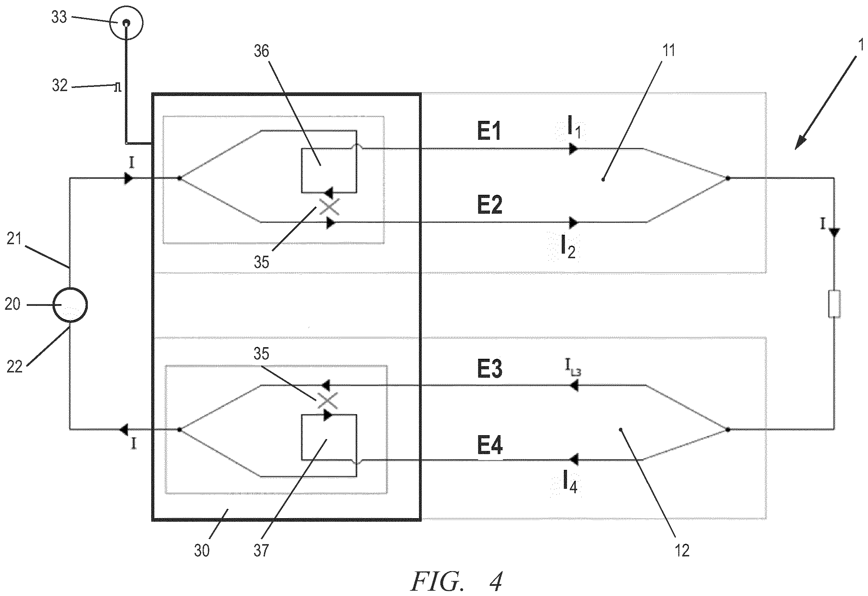

Im Ausführungsbeispiel nach Fig. 4 ist eine Überwachungsvorrichtung 30 dargestellt, die die resultierenden elektromagnetischen Differenzfelder der in den Einzelleitern E1 und E2 bzw. E3 und E4 fließenden Ströme I₁ und I₂ bzw. I₃ und I₄ erfasst und auswertet. In einer einfachen Ausgestaltung ist vorgesehen, einen Magnetfeldsensor, insbesondere einen Hallsensor 35 zu verwenden. Wie im Leitungspfad 11 dargestellt, wird die Einzelleitungen E1 mit einer Schleife 36 verlegt, sodass der Strom I₁ im Einzelleiter E1 am Hallsensor 35 in Gegenrichtung zum Strom I₂ im Einzelleiter E2 fließt. Sind die Ströme I₁ und I₂ gleich, gibt der Hallsensor 35 kein Signal ab. Haben die Ströme I₁ und I₂ unterschiedliche Größen, liegt ein Fehler vor. Der Hallsensor 35 gibt ein Ausgangssignal an die Überwachungsvorrichtung 30 ab. Diese wird ein den Fehler anzeigendes Ausgangssignal 32 abgeben und/oder eine Abschalteinrichtung 40 betätigen.

Auch die in den Einzelleitern E3 und E4 des Leitungspfades 12 fließenden Ströme I₃ und I₄ werden durch einen Hallsensor 35 überwacht. Damit am Hallsensor 35 die Ströme einander gegengerichtet sind, wird der Einzelleiter E4 mit einer Schleife 37 verlegt.

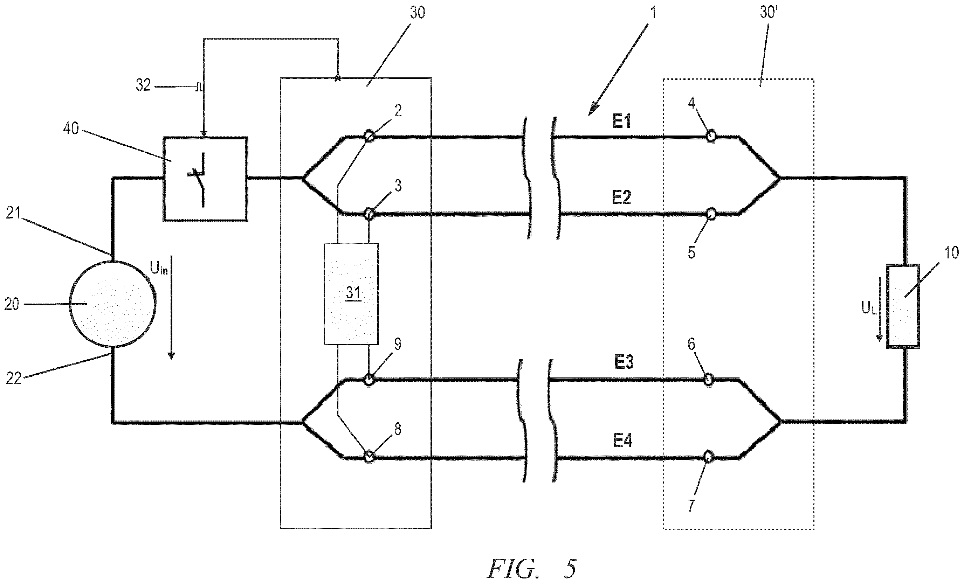

Im Ausführungsbeispiel nach Fig. 5 ist ein Überwachungsvorrichtung 30 bzw. 30' gezeigt, welche die Temperaturen an jeweils vorgewählten Verbindungsstellen 2, 3, 4, 5, 6, 7, 8 oder 9 der Einzelleiter E1, E2, E3 oder E4 erfasst und auswertet. Am Beispiel der Überwachungsvorrichtung 30 ist gezeigt, wie mittels einer Überwachungselektronik 31 die Temperaturen an den Verbindungsstellen 2 und 3 an dem einen Ende des Leitungspfades 11 und/oder die Temperaturen an den Verbindungsstellen 8 und 9 an dem anderen Ende des Leitungspfades 12 erfasst und miteinander verglichen werden. Bei einer auftretenden Temperaturdifferenz wird ein Signal ausgegeben und/oder eine Abschalteinrichtung 40 ausgelöst. Ein Verbindungsstellen 2 bis 9 der Einzelleiter E1, E2, E3 oder E4 kann eine Lötstelle, ein Klemmanschluss, ein Steckanschluss oder eine Verbindung auf einer Leiterplatte der Überwachungselektronik 31 sein.

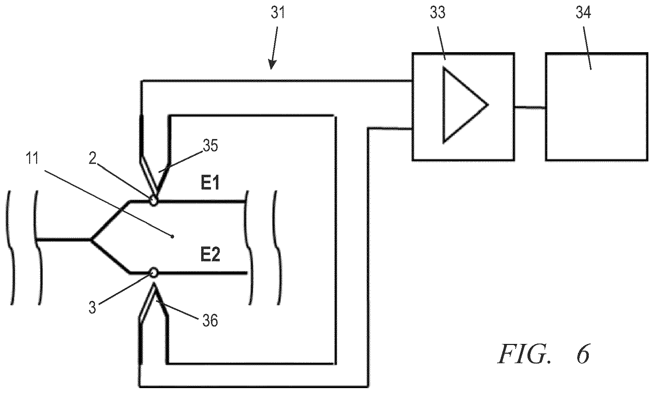

In Fig. 6 ist schematisch eine Überwachungselektronik 31 gezeigt, die die Temperaturen der an einem Ende des Leitungspfades 11 gegebenen Verbindungsstellen 2 und 3 erfasst und auswertet. Ein erster an der Verbindungsstelle 2 angeordneter Temperatursensor 35 liegt bevorzugt in Reihe mit einem an der Verbindungsstelle 3 angeordneten Temperatursensor 36. Über einen Differenzverstärker 33 wird das Differenzsignal der Temperatursensoren 35 und 36 verstärkt und in einem Mikroprozessor 34 ausgewertet.

## Patentansprüche

1. Vorrichtung mit einer elektrischen Versorgungsleitung (1) zwischen einem elektrischen Verbraucher (10) und einer Gleichspannungsquelle (20) mit einem Plus-Pol (21) und einem Minus-Pol (22), wobei die Versorgungsleitung (1) die zum Betrieb des Verbrauchers (10) notwendige elektrische Energie zuführt,
**dadurch gekennzeichnet,**
**dass** die elektrische Versorgungsleitung (1) aus zumindest vier nebeneinander verlaufenden, identisch ausgebildeten und isolierten Einzelleitern (E1, E2, E3, E4) gleicher Länge (L) besteht, wobei zumindest zwei Einzelleiter (E1, E2) den positiven Pol (21) mit dem Verbraucher (10) und zumindest zwei Einzelleiter (E3, E4) den negativen Pol (22) mit dem Verbraucher (10) verbinden, und dass jeder der Einzelleiter (E1, E2, E3, E4) eine selbständige elektrische Verbindung zwischen der Gleichspannungsquelle (20) und dem elektrischen Verbraucher (10) bildet.

2. Vorrichtung nach Anspruch 1,
**dadurch gekennzeichnet, dass** die zumindest vier Einzelleiter (E1, E2, E3, E4) in einem gemeinsamen Verbindungskabel (15) zusammengefasst sind.

3. Vorrichtung nach Anspruch 1 oder 2,
**dadurch gekennzeichnet, dass** die Einzelleiter (E1, E2, E3, E4) einen gleichen elektrischen Widerstand (R₁, R₂, R₃, R₄) und/oder einen gleichen Querschnitt haben und/oder aus einem gleichen Material wie einer gleichen Legierung bestehen.

4. Vorrichtung nach einem der Ansprüche 1 bis 3,
**dadurch gekennzeichnet, dass** alle Einzelleiter (E1, E2, E3, E4) auf zumindest den Nennstrom des angeschlossenen Verbrauchers (10) ausgelegt sind.

5. Vorrichtung nach einem der Ansprüche 1 bis 4,
**dadurch gekennzeichnet, dass** die Gleichspannungsquelle (20) eine Versorgungsspannung (U) zwischen 24V und 120V aufweist.

6. Vorrichtung nach einem der Ansprüche 1 bis 5,
**dadurch gekennzeichnet, dass** zwischen je zwei Einzelleitern (E1, E2; E3, E4) zumindest eine Überwachungsvorrichtung (30) angeordnet ist.

7. Vorrichtung nach Anspruch 6,
**dadurch gekennzeichnet, dass** die Überwachungsvorrichtung (30) zwischen den Einzelleitern (E1, E2) des den positiven Pol (21) der Gleichspannungsquelle (20) mit dem Verbraucher (10) verbindenden Leitungspfad (11) und/oder zwischen den Einzelleitern (E3, E4) des den negativen Pol (22) der Gleichspannungsquelle (20) mit dem Verbraucher (10) verbindenden Leitungspfad (12) vorgesehen ist.

8. Vorrichtung nach einem der Ansprüche 6 bis 7,
**dadurch gekennzeichnet, dass** die Überwachungsvorrichtung (30) ausgebildet ist, die in den Einzelleitungen (E1, E2, E3, E4) fließenden Ströme (I₁, I₂, I₃, I₄) miteinander zu vergleichen und bei einer Stromdifferenz ein Signal (32) abzugeben und/oder eine Abschalteinrichtung (40) auszulösen.

9. Vorrichtung nach einem der Ansprüche 6 bis 8,
**dadurch gekennzeichnet, dass** zur Erfassung der in den Einzelleitern (E1, E2, E3, E4) fließenden Ströme (I₁, I₂, I₃, I₄) in einem Einzelleiter (E1, E2, E3, E4) jeweils ein Stromsensor (25) angeordnet ist.

10. Vorrichtung nach einem der Ansprüche 6 bis 9,
**dadurch gekennzeichnet, dass** die Überwachungsvorrichtung (30) ausgebildet ist, die elektromagnetischen Felder der in den Einzelleitern (E1, E2, E3, E4) fließenden Ströme (I₁, I₂, I₃, I₄) zu erfassen und auszuwerten.

11. Vorrichtung nach einem der Ansprüche 6 bis 10,
**dadurch gekennzeichnet, dass** die Überwachungsvorrichtung (30) ausgebildet ist, die elektromagnetischen Felder der Ströme (, I_{2;} I₃, I₄) von je zwei Einzelleitern (E1, E2; E3, E4) miteinander zu vergleichen und bei einer Felddifferenz ein Signal (32) abzugeben und/oder eine Abschalteinrichtung (40) auszulösen.

12. Vorrichtung nach einem der Ansprüche 6 bis 11,
**dadurch gekennzeichnet, dass** die Überwachungsvorrichtung (30) ausgebildet ist, die Temperatur an jeweils einer vorgewählten Verbindungsstelle (2 bis 9) der Einzelleiter (E1, E2, E3, E4) zu erfassen und auszuwerten.

13. Vorrichtung nach einem der Ansprüche 6 bis 12,
**dadurch gekennzeichnet, dass** die Überwachungsvorrichtung (30) ausgebildet ist, die Temperaturen an den vorgewählten Verbindungsstellen (2 bis 9) der Einzelleiter (E1, E2, E3, E4) miteinander zu vergleichen und bei einer Temperaturdifferenz ein Signal (32) auszugeben und/oder eine Abschalteinrichtung (40) auszulösen.

14. Vorrichtung nach Anspruch 12 oder 13,
**dadurch gekennzeichnet, dass** die Verbindungsstelle (2 bis 9) der Einzelleiter (E1, E2, E3, E4) eine Lötstelle, ein Klemmanschluss, ein Steckanschluss oder eine Verbindung auf einer Leiterplatte oder dgl. ist.

15. Vorrichtung nach einem der Ansprüche 6 bis 14,
**dadurch gekennzeichnet, dass** die Überwachungsvorrichtung (30) eine Steckbuchse (17) zum Anschluss der zum Verbraucher (10) führenden Verbindungsleitung (1) aufweist.
